# EUROPÄISCHE PATENTANMELDUNG

(11) **EP 4 676 173 A1**
(43) Veröffentlichungstag der Anmeldung: **07.01.2026**
(21) Anmeldenummer: 25185648.0
(22) Anmeldetag: 26.06.2025
(51) Int. Cl.: H05K 5/00, H05K 5/15

(54) **GEHÄUSE UND EIN VERFAHREN ZUR HERSTELLUNG EINES GEHÄUSES**

(30) Priorität: 01.07.2024 DE 102024118515
(71) Anmelder: KB Intellectual Property GmbH & Co. KG, 82049 Pullach (DE)
(72) Erfinder: KLASKI, Jens, 74360 Ilsfeld (DE); RAISER, Timo, 74321 Bietigheim-Bissingen (DE)

(57) **Zusammenfassung**

Ein Gehäuse mit einer Bodenkomponente (100) aus einem nicht-deformierbaren Material und einer Deckelkomponente (200) ist offenbart. Die Bodenkomponente (100) umfasst eine oder mehrere Befestigungsöffnungen (110). Die Deckelkomponente (200) umfasst ein oder mehrere Rastelemente (210). Die Rastelemente (210) sind in die Befestigungsöffnungen (110) einrastbar, um die Bodenkomponente (100) durch die Deckelkomponente (200) fest zu verschließen. Die Rastelemente (210) bilden Nasen (215), die nach dem Verschließen von dem Gehäuse wegzeigen.

## Beschreibung

Die vorliegende Erfindung bezieht sich auf ein Gehäuse und ein Verfahren zur Herstellung eines Gehäuses und insbesondere auf eine Deckelverschnappung zur Reduktion von Ausfällen durch Dimensionsänderungen infolge von hygroskopischen Polymeren.

Bei konventionellen Gehäusen werden Deckel auf Module mit Schrauben oder mittels Schnapphaken auf einer Gehäusebodenkomponente montiert. Der Schnapphaken ist dabei in der Regel nach innen gerichtet, um ein leichtes Öffnen und Schließen des Gehäuses zu ermöglicht. So kann beispielsweise der Schnapphaken ohne Probleme nach außen gebogen werden und aus der Verschnappung gelöst werden.

Diese übliche Bauweise hat einige Probleme. Zunächst ist die Herstellung des Deckels aufwendig. Deckel werden häufig in einem Spritzgussverfahren oder einem Gießverfahren hergestellt. Die nach innen gerichteten Schnapphaken erfordern im Spritzwerkzeug nach innen verschiebbare Vorsprünge (Schieber), um den Deckel nach der Fertigung aus dem Werkzeug zu bekommen. Aufgrund von sicherheitsrelevanten Merkmalen sind die Deckel daher schwer herzustellen bzw. schwer zu kontrollieren. Ein weiterer Nachteil dieser konventionellen Gehäuse besteht darin, dass Deckel häufig hygroskopische Polymere aufweisen, die den Nachteil haben, dass sie ihre Dimension (Ausdehnung) in einem nicht unerheblichen Maß ändern können. Das Ausdehnen dieser Materialien (z.B. bei Feuchtigkeit) kann zu einem Lösen der Schnappverbindung führen, da die Schnapphaken sich in Richtung Lösestellung verschieben. Gerade im Fahrzeugbereich führt dies immer wieder zu Undichtigkeiten, was für viele Komponenten nicht akzeptabel ist.

Daher besteht ein Bedarf nach alternativen Gehäusen, die eine sichere Schnappverbindung für Deckel - auch wenn sie sich ausdehnen - sicherstellen.

Zumindest ein Teil der obengenannten Probleme wird durch ein Gehäuse nach Anspruch 1 und ein Verfahren zu seiner Herstellung nach Anspruch 9. Die abhängigen Ansprüche definieren weitere vorteilhafte Ausführungsformen der Gegenstände der unabhängigen Ansprüche.

Die vorliegende Erfindung bezieht sich auf ein Gehäuse mit einer Bodenkomponente aus einem nicht-deformierbaren Material und einer Deckelkomponente. Die Bodenkomponente umfasst eine oder mehrere Befestigungsöffnungen und die Deckelkomponente umfasst ein oder mehrere Rastelemente. Die Rastelemente sind in die Befestigungsöffnungen einrastbar, um die Bodenkomponente durch die Deckelkomponente fest zu verschließen. Die Rastelemente bilden Nasen, die nach dem Verschließen von dem Gehäuse wegzeigen.

Im Rahmen der vorliegenden Offenbarung wird überwiegend von mehreren Befestigungsöffnungen und mehreren Rastelementen ausgegangen. Jedoch sollen Ausführungsbeispiele darauf nicht beschränkt werden. So reicht es beispielsweise zum Verschließen des Gehäuses aus, wenn nur eine Befestigungsöffnung und nur ein Rastelement mit einer daran befindlichen Nase ausgebildet ist. Auf einer gegenüberliegenden Seite des Gehäuses kann dann beispielsweise ein Scharnier oder eine ähnliche drehbare Halterung ausgebildet sein, sodass auch dann ein festes und zuverlässiges Verschließen des Gehäuses möglich ist. Es hat jedoch Vorteile, wenn an verschiedenen Seiten, beispielsweise an allen Seiten, Befestigungsöffnungen und zugehörige Rastelemente ausgebildet werden. An jedem Rastelement kann dann eine entsprechende Nase ausgebildet werden.

Optional umfasst die Deckelkomponente ein Material aus hygroskopischen Polymeren. Die Bodenkomponente kann ein Gussmaterial (z.B. Eisenguss oder Aluminiumguss) oder ein gefrästes Material aufweisen. Beispiele für hygroskopische Polymere sind Polyamide (PA) wie PA6 (Polycaprolactam), PA6X (verschieden x-Werte), PPA (Polyphthalamide).

Optional sind die Nasen der Rastelemente monolithisch jeweils als ein Keil gebildet, wobei der abgeschrägte Abschnitt des Keiles auf Seite ausgebildet sein kann, die vom

Gehäuse weg zeigt. Die Nasen können zum Beispiel in Richtung hin zu einer Außenwand der Bodenkomponente eine kontinuierlich zunehmende Dicke aufweisen und sind dementsprechend nicht als eine federnde Zunge ausgebildet. Die Dicke der Nasen ändert sich somit in eine Einschubrichtung (Einrastrichtung) in die Befestigungsöffnungen kontinuierlich.

Insbesondere können die Nasen an einer rückseitigen Fläche der Nasen optional bündig mit einer Außenwand der Bodenkomponente abschließen. Dadurch werden die Nasen beim Einrasten in die Befestigungsöffnungen durch die Außenfläche der Bodenkomponente abgestützt (können nicht einfedern). Insbesondere brauchen keine Hohlräume zwischen der Rückseite der Nasen und der Außenwand der Bodenkomponente vorhanden sein. Das hat den technischen Effekt, dass die Nasen nichtfedernd einrasten können und ein beschädigungsfreies Lösen nach dem Zusammensetzen nicht mehr ohne Weiteres möglich ist. Beim Einrasten kann es natürlich zu einer Deformation (Zusammendrücken) der Nasen kommen, wobei sich die Deformation nach dem Einrasten wieder entspannt.

Optional umfasst die Bodenkomponente in Einrastrichtung hinter den Befestigungsöffnungen einen oder mehrere keilförmige Vorsprünge an einer Außenwand der Bodenkomponente. Die keilförmigen Vorsprünge können ausgebildet sein, um die Nasen von der Außenwand der Bodenkomponente wegzudrücken. Das bietet den Vorteil, dass die Einrastwirkung verstärkt wird und ein späteres zerstörungsfreies Lösen nahezu unmöglich wird, da die keilförmigen Vorsprünge eine Vorspannung auf die Nasen bewirken.

Optional umfasst das Gehäuse weiter ein Dichtelement aus einem elastischen Material (z.B. einen Gummiring), um die Bodenkomponente durch die Deckelkomponente dicht zu verschließen. Die Rastelemente können in die Befestigungsöffnungen beispielsweise nur bei einer Deformation des Dichtelementes einrasten. Die Dichtung wirkt also als Feder. Es handelt sich hierbei um eine Einschränkung an vertikaler Ausdehnung Deckelkomponente und/oder dem Abstand der Befestigungsöffnungen von einem Rand der Bodenkomponente, der von dem Deckel verschlossen wird. Die Dichtung kann am Rand der Bodenkomponente oder an einer Innenfläche der Deckelkomponente ausgebildet werden.

Ausführungsbeispiele beziehen sich auch auf eine Fahrzeugkomponente mit einem zuvor beschriebenen Gehäuse. Die Fahrzeugkomponente kann zumindest eines aus dem Folgenden aufweisen oder Folgendes sein: ein elektropneumatischer Modulator, eine elektronische Komponente, ein Steuergerät, eine elektronische Lenkunterstützung, ein elektronischer Kupplungsaktuator, ein Anhängesteuermodul, ein Fußbremsmodul, ein Drucksteuerventil.

Ausführungsbeispiele beziehen sich auch auf ein Nutzfahrzeug, insbesondere auf einen Lastkraftwagen oder einen Bus, mit einer zuvor beschriebenen Fahrzeugkomponente.

Ausführungsbeispiele beziehen sich auch auf ein Verfahren zur Herstellung des zuvor beschriebenen Gehäuses. Das Verfahren kann folgende Schritte umfassen:
- Bilden einer Bodenkomponente aus einem nicht-deformierbaren Material mit Befestigungsöffnungen;
- Bilden einer Deckelkomponente zum dichten Verschließen der Bodenkomponente, wobei Deckelkomponente Rastelemente mit Nasen aufweist, die nach einem Verschließen vom Gehäuse wegzeigen.

Es versteht sich, dass alle zuvor beschriebenen Merkmale des Gehäuses durch weitere optionale Verfahrensschritte hergestellt werden können. Außerdem versteht es sich, dass die Reihenfolge der Nennung nicht notwendigerweise eine Reihenfolge bei der Ausführung der Verfahrensschritte bedeutet. Die Schritte können auch in einer anderen Reihenfolge ausgeführt werden. Es braucht auch nur ein Teil der Verfahrensschritte ausgeführt werden.

Ausführungsbeispiele überwinden somit die Probleme der konventionellen Gehäuse durch Schnapphaken (Rast- oder Einrastelemente), die von einem Gehäuseinnenraum aus gesehen nach außen gerichtet sind, d.h. die Vorsprünge (Nasen) zeigen vom Gehäuse weg und verschnappen in Schlaufen (Befestigungsöffnungen) des Gehäusebodenteils (Bodenkomponente). Das hat zur Folge, dass ein Ausdehnen des Deckels (Deckelkomponente) nicht mehr zu einem Lösen der Schnappverbindung führen kann, da die Schnappwirkung durch die Ausdehnung eher verstärkt als geschwächt wird. Ein weiterer Vorteil besteht darin, dass bei dieser Anordnung teure Schieber im Deckelspritzgusswerkzeug vermieden werden können, da die Ausrichtung der Nasen eine fertigungsgerechte Entformung zulässt. Beispielsweise kann die Fertigungsform einfach auseinandergeschoben werden, was bei einer konventionellen, entgegengesetzten Ausrichtung der Rastelemente nicht möglich ist. Schließlich haben Ausführungsbeispiele den Vorteil, dass Nasen, die nach dem Einrasten an einer Rückseite bündig mit der Bodenkomponente abschließen, eine nachträgliche zerstörungsfreie Demontage des Deckels verhindern oder erschweren. Somit kann jedes (unzulässige) Öffnen des Gehäuse festgestellt werden.

Die Ausführungsbeispiele der vorliegenden Erfindung werden besser verstanden von der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fign. 1A,1B: zeigen ein Gehäuse gemäß einem Ausführungsbeispiel der vorliegenden Erfindung.
- Fig. 2: veranschaulicht weitere Details des Gehäuses gemäß weiterer Ausführungsbeispiele
- Fig. 3: zeigt eine schematische Darstellung eines Flussdiagrammes für ein Verfahren zur Herstellung des Gehäuses.

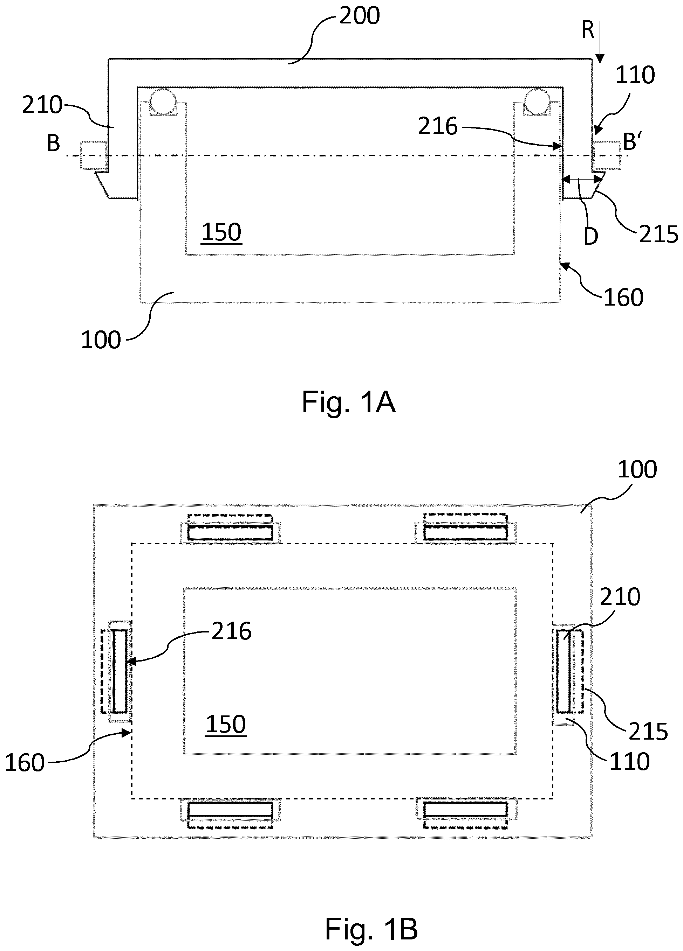

**Fig. 1A** zeigt ein Ausführungsbeispiel für ein Gehäuse mit einer Bodenkomponente 100 aus einem nicht-deformierbaren Material und einer Deckelkomponente 200, die einen Innenraum 150 des Gehäuses umschließen. Die Bodenkomponente 100 umfasst Befestigungsöffnungen 110 und die Deckelkomponente 200 umfasst dazugehörige Rastelemente 210. Die Rastelemente 210 weisen jeweils eine Nase 215 auf, die in die Befestigungsöffnungen 110 einrastbar sind, um die Bodenkomponente 100 durch die Deckelkomponente 200 fest zu verschließen. Die Nasen 215 sind derart gebildet, dass sie nach dem Verschließen des Gehäuses von einem Innenraum 150 des Gehäuses wegzeigen.

Gemäß Ausführungsbeispielen sind die Nasen 215 der Rastelemente 210 monolithisch als ein Keil geformt. Eine Dicke D der Nasen 215, die in einer Richtung senkrecht zu einer Seitenwand 160 gemessen wird, ändert sich monoton in der Einschubrichtung R der Rastelemente 210 in Befestigungsöffnungen 110 der Bodenkomponente 100. Da außerdem eine rückseitige Fläche 216 der Nasen 215 bündig mit einer Außenwand 160 der Bodenkomponente 100 abschließen, werden die Nasen 215 beim Einrasten in die Befestigungsöffnungen 110 durch die Außenfläche 160 abgestützt. Sie können somit nicht mehr zurückgedrückt werden. Das Einsetzen der Rastelemente 210 in die Befestigungsöffnungen 110 kann daher durch eine Deformation der Nasen 215 erfolgen - nicht aber durch eine Federeffekt wie z.B. bei einem Verkippen von zungenförmigen Vorsprüngen. Das Letztere hätte den Nachteil, dass das Gehäuse auf einfache Weise erneut geöffnet werden kann, was Ausführungsbeispiele verhindern wollen.

**Fig. 1B** zeigt das gleiche Gehäuse entlang der Querschnittlinie B-B' aus der Fig. 1A, sodass der Innenraum 150 zentral angeordnet ist und von der Bodenkomponente 100 lateral umschlossen wird.

Auch wenn Ausführungsbeispiele sich auch auf den Fall beziehen, dass nur ein Rastelement 210 in nur einer Befestigungsöffnung 110 einrastet (auf der anderen Seite könnte ein Scharnier), ist es vorteilhaft, wenn an verschiedenen Seiten des Gehäuses eine oder mehrere Rastelemente 210 mit dazugehörigen Befestigungsöffnungen 110 vorgesehen sind. Gemäß dem gezeigten Ausführungsbeispiel können an einer langen Seite des rechteckigen Gehäuses jeweils zwei Rastelemente 210 und jeweils zwei dazugehörige Befestigungsöffnungen 110 ausgebildet sein und an den kurzen Seiten des Gehäuses jeweils ein Rastelement 210 mit einer dazugehörigen Befestigungsöffnung 110 ausgebildet sein. Somit werden alle Seiten des Gehäuses zuverlässig gesichert.

Auch wenn in dem gezeigten Ausführungsbeispiel die Befestigungsöffnungen 110 in einem umlaufenden Schulterbereich um die Außenwand 160 der Bodenkomponente 100 herum ausgebildet sind, können gemäß weiterer Ausführungsbeispielen die Befestigungsöffnungen 110 in Laschen oder Schlaufen ausgebildet sein. Ebenso können die Rastelemente 210, wie auch die Befestigungsöffnungen 110, beliebige Formen aufweisen. Der gezeigte rechteckförmige Querschnitt (senkrecht zur Einschubrichtung R) bietet den Vorteil, dass eine zuverlässige Einrastung sichergestellt werden kann, und zwar selbst dann, wenn die Deckelkomponente 200 sich bei Feuchtigkeit beträchtlich ausdehnt.

Gemäß Ausführungsbeispielen kann die Deckelkomponente 200 nämlich ein Material aus hygroskopischen Polymeren aufweisen. Daher kann insbesondere ein Polyamid (PA, PA6, PA6X, PPA) als Material für die Deckelkomponente 200 genutzt werden. Die Bodenkomponente 100 kann als ein Gussmaterial (z.B. Eisen oder Aluminium) oder ein gefrästes Material aufweisen.

Unter Einwirkung einer Feuchtigkeit wird sich die Bodenkomponente 100 daher kaum oder gar nicht ändern. Jedoch wird die Deckelkomponente 200 bei Feuchtigkeit sich ausdehnen (hygroskopischer Effekt). Da jedoch die Nasen 215 sich von der Außenwand 160 der Bodenkomponente 100 aus weg erstrecken, führt eine Ausdehnung der Deckelkomponente 200 dazu, dass die Einrastung sich eher verstärkt - nicht aber dazu, dass sich der Einrastung der Deckelkomponente 200 löst. Ein Lösen der Verrastung durch die Rastelemente 110 (Schnapphaken) infolge von Größenänderungen (Dimensionsänderungen), die beispielsweise durch eine Wasseraufnahme der Deckelkomponente 200 entstehen kann, ist somit ausgeschlossen.

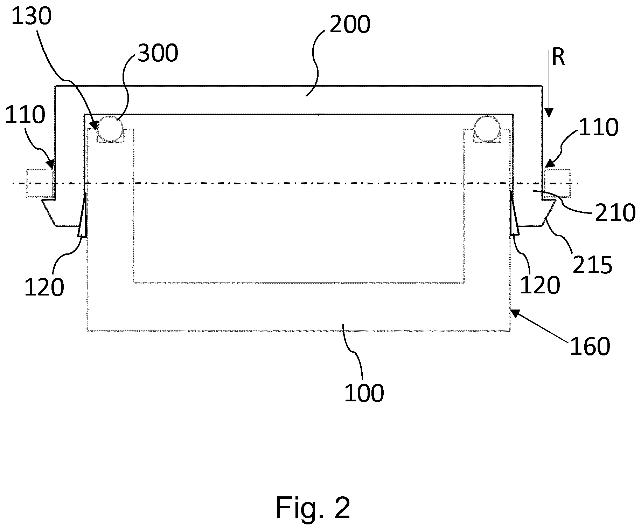

**Fig. 2** veranschaulicht weitere optionale Details des Gehäuses gemäß weiterer Ausführungsbeispiele.

Gemäß dem gezeigten Ausführungsbeispiel umfasst die Bodenkomponente 100 in der Einrastrichtung R hinter den Befestigungsöffnungen 110 einen oder mehrere keilförmige Vorsprünge 120 an der Außenwand 160 der Bodenkomponente 100. Die keilförmigen Vorsprünge 120 drücken die Nasen 215 von der Außenwand 160 der Bodenkomponente 100 aus weg und verstärken somit den Einrasteffekt. Das bietet den Vorteil, dass nach dem Einrasten ein Zurückbiegen der Nase 215 hin zu der Außenwand 160 nahezu ausgeschlossen. Die keilförmigen Vorsprünge 120 bewirken eine Vorspannung für die Einrastelemente 210 (nach dem Einrasten), sodass die Verrastung zuverlässig geschützt wird.

Gemäß dem gezeigten Ausführungsbeispiel umfasst das Gehäuse außerdem zumindest ein Dichtelement 300 aus einem elastischen Material (z.B. ein Gummiring), welches zwischen der Bodenkomponente 100 und der Deckelkomponente 200 ausgebildet ist, um das Gehäuse dicht zu verschließen. Das Dichtelement 300 kann beispielsweise in einer Nut 130 in einem Randbereich der Bodenkomponente 100 ausgebildet werden. Das Dichteelement 300 kann jedoch ebenfalls in einem Innenbereich der Deckelkomponente 200 ausgebildet werden, um den Randbereich des Bodenkomponente 100 zu kontaktieren.

Die Abmaße können beispielsweise derart gewählt werden, dass nach dem Einrasten der Rastelemente 210 in den Befestigungsöffnungen 110, das Dichtelement 300 deformiert ist und so eine zuverlässige Abdichtung sichergestellt wird.

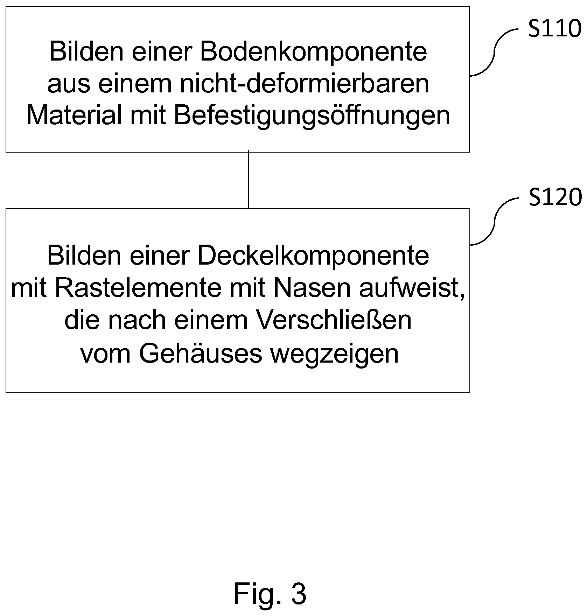

**Fig. 3** zeigt eine schematische Darstellung eines Flussdiagrammes für ein Verfahren zur Herstellung des Gehäuses. Das Verfahren umfasst die Schritte:
- Bilden S110 einer Bodenkomponente 100 aus einem nicht-deformierbaren Material mit Befestigungsöffnungen 110;
- Bilden S120 einer Deckelkomponente 200 zum dichten Verschließen der Bodenkomponente 100, wobei Deckelkomponente 200 Rastelemente 210 mit Nasen 215 aufweist, die nach einem Verschließen vom Gehäuses wegzeigen

Ausführungsbeispiele sind insbesondere anwendbar auf Gehäuse mit Bodenkomponenten 100, die ein Gussmaterial (z.B. Eisenguss oder Aluminiumguss oder ähnliches) aufweisen, und die Deckelkomponente 200 ein beliebiges Material umfassen kann. Ausführungsbeispiele sind aber insbesondere vorteilhaft einsetzbar für den Einsatz von hygroskopischen Polymeren für die Deckelkomponente 100, wie beispielsweise PA6, PA66, PPA, die in Kombination mit einem Gussmaterial für die Bodenkomponente 100 genutzt werden können. Die Ausrichtung der Rastelemente 210 stellen dabei eine zuverlässige Verrastung sicher.

Ausführungsbeispiele sind vielfältig einsetzbar, z.B. für einen elektropneumatischen Modulator, Steuergeräte, elektronische Lenkunterstützungen, elektronische Kupplungsaktuatoren, Anhängesteuermodule, Fußbremsmodule, Drucksteuerventile.

Ein weiterer Vorteil von Ausführungsbeispielen besteht in einem Sicherheitsaspekt. Es ist häufig so, dass ein unbefugtes Öffnen von Gehäusen verhindert oder zumindest feststellbar sein soll, um Manipulationen an sicherheitsrelevanter Elektronik oder anderen Sicherheitsrelevanten Komponenten auszuschließen. Ausführungsbeispiele sind insbesondere für solche Gehäuse einsetzbar, da nach dem Schließen das Gehäuse, diese nur noch durch eine Zerstörung geöffnet werden können. Trotzdem kann das Gehäuse durch einfach Einrasten schnell und einfach geschlossen werden. Ausführungsbeispiele erreichen dies durch Rastelemente mit monolithisch gebildeten Nasen, die nicht mehr ohne Weiteres aus den Befestigungsöffnungen 110 herausgeführt werden können, da die Rastelemente 210 mit ihrer Rückseite 216 direkt an einer Außenwand 160 der Bodenkomponente 100 anstoßen. Ein Rückbiegen der Rastelemente 210 zum Herausführen der Nasen 215 aus den Befestigungsöffnungen 110 ist daher unmöglich.

Weitere Vorteile beziehen sich auf die kostengünstige Herstellung der Deckelkomponente 100 und der Bodenkomponente 200, die für die Kombination von hygroskopischen Materialien mit Gussmaterialien besonders geeignet sind. Auch wenn die Deckelkomponente 200 bis zu einem gewissen Umfang Wasser aufnimmt und dadurch an Größe gewinnt, bleibt die Verbindung zwischen der Bodenkomponente 100 und der Deckelkomponente 200 trotz Größenzunahme zuverlässig sichergestellt. Die nach Außen zeigende Verrastung wird durch ein Anwachsen der Größe der Deckelkomponente 200 eher noch unterstützt als gefährdet.

Außerdem können Toleranzen bei der Herstellung der Deckelkomponente 100 verringert werden, was ansonsten die Herstellbarkeit der Deckelkomponente 100 erschweren würde. Ein weiterer grundlegender Vorteil ist die Kostenreduktion, die dadurch entsteht, dass in dem Herstellungsverfahren, keine Schieber oder anderen bewegliche Vorsprünge gebraucht werden. Vielmehr kann durch eine geschickte Auslegung der Elemente in Richtung einer allgemeinen Werkzeugöffnung auf solche Elemente ganz verzichtet werden.

Die in der Beschreibung, den Ansprüchen und den Figuren offenbarten Merkmale der Erfindung können sowohl einzeln als auch in beliebiger Kombination für die Verwirklichung der Erfindung wesentlich sein.

### BEZUGSZEICHENLISTE

- 100: Bodenkomponente
- 110: Befestigungsöffnung(en)
- 120: keilförmiger Vorsprung
- 130: umlaufende Nut am Rand des Bodenelementes
- 150: Gehäuseinnenraum
- 160: Außenwand der Bodenkomponente
- 200: Deckelkomponente
- 210: Rastelelement(e)
- 215: Nase(n)
- 216: rückseitige Fläche der Nase
- 300: Dichtelement
- D: Dicke der Nase(n)
- R: Einschubrichtung, Einrastrichtung

## Patentansprüche

1. Gehäuse mit einer Bodenkomponente (100) aus einem nicht-deformierbaren Material und einer Deckelkomponente (200), wobei die Bodenkomponente (100) eine oder mehrere Befestigungsöffnungen (110) aufweist und die Deckelkomponente (200) ein oder mehrere Rastelemente (210) aufweist und die Rastelemente (210) in die Befestigungsöffnungen (110) einrastbar sind, um die Bodenkomponente (100) durch die Deckelkomponente (200) fest zu verschließen,
**dadurch gekennzeichnet, dass**
die Rastelemente (210) Nasen (215) bilden, die nach dem Verschließen von dem Gehäuse wegzeigen.

2. Gehäuse nach Anspruch 1,
wobei die Deckelkomponente (200) ein Material aus hygroskopischen Polymeren aufweist und die Bodenkomponente (100) zumindest eines der folgenden Materialien aufweist: ein Aluminiumguss, ein Eisenguss, ein gefrästes Material.

3. Gehäuse nach Anspruch 1 oder Anspruch 2, wobei die Nasen (215) der Rastelemente (210) monolithisch einen Keil bilden.

4. Gehäuse nach einem der vorhergehenden Ansprüche, wobei eine rückseitige Fläche (216) der Nase (215) bündig mit einer Außenwand (160) der Bodenkomponente (100) abschließt und die Nasen (215) beim Einrasten in die Befestigungsöffnungen (110) durch die Außenfläche (160) der Bodenkomponente (100) abgestützt werden.

5. Gehäuse nach einem der vorhergehenden Ansprüche, wobei die Bodenkomponente (100) in Einrastrichtung R hinter den Befestigungsöffnungen (110) einen oder mehrere keilförmige Vorsprünge (120) an einer Außenwand (160) der Bodenkomponente (100) aufweist und die keilförmigen Vorsprünge (120) die Nasen (215) von der Außenwand (160) der Bodenkomponente (100) wegdrücken.

6. Gehäuse nach einem der vorhergehenden Ansprüche, das weiter ein Dichtelement (300) aus einem elastischen Material aufweist, um die Bodenkomponente (100) durch die Deckelkomponente (200) dicht zu verschließen, wobei die Rastelemente (210) in die Befestigungsöffnungen (110) nur bei Deformation des Dichtelementes (300) einrasten.

7. Eine Fahrzeugkomponente mit einem Gehäuse nach einem der vorhergehenden Ansprüche, wobei die Fahrzeugkomponente zumindest eines aus dem Folgenden aufweist oder eines aus dem Folgendes ist: ein elektropneumatischer Modulator, eine elektronische Komponente, ein Steuergerät, eine elektronische Lenkunterstützung, ein elektronischer Kupplungsaktuator, ein Anhängesteuermodul, ein Fußbremsmodul, ein Drucksteuerventil.

8. Nutzfahrzeug, insbesondere ein Lastkraftwagen oder ein Bus mit einer Fahrzeugkomponente nach Anspruch 7.

9. Verfahren zur Herstellung eines Gehäuses mit folgenden Schritten:
- Bilden (S110) einer Bodenkomponente (100) aus einem nicht-deformierbaren Material mit Befestigungsöffnungen (110);
- Bilden einer Deckelkomponente (200) zum dichten Verschließen der Bodenkomponente (100), wobei Deckelkomponente (200) Rastelemente (210) mit Nasen (215) aufweist, die nach einem Verschließen vom Gehäuses wegzeigen.
